# EUROPEAN PATENT APPLICATION

(11) **EP 1 093 081 A1**
(43) Date of publication of application: **18.04.2001**
(21) Application number: 00122093.8
(22) Date of filing: 11.10.2000
(51) Int. Cl.: G06K 19/077

(54) **Integrated circuit chip, method of manufacturing the same, IC card, and method of manufacturing the same**

(30) Priority: 14.10.1999 JP 29216499
(71) Applicant: Nippon Telegraph and Telephone Corporation, Tokyo 100-8116 (JP)
(72) Inventor: Unno, Hideyuki, c/o NTT Intellectual Property Cent, Musashino-Shi, Tokyo 180-8585 (JP); Ohfuji, Shin-ichi, NTT Intellectual Property Cent, Musashino-Shi, Tokyo 180-8585 (JP); Itsumi, Manabu, c/o NTT Intellectual Property Cent, Musashino-Shi, Tokyo 180-8585 (JP); Takeda, Tadao, c/o NTT Intellectual Property Cent, Musashino-Shi, Tokyo 180-8585 (JP)
(74) Representative: Haft, von Puttkamer, Berngruber, Czybulka

(57) **Abstract**

An integrated circuit chip includes an integrated circuit body and a reinforcing member. The integrated circuit body has a predetermined integrated circuit formed on the major surface. The reinforcing member is formed by a fiber reinforced plastic obtained by compounding a resin with a fiber material and is bonded to almost the entire lower surface of the integrated circuit body. An IC card, integrated circuit chip manufacturing method, and IC card manufacturing method are also disclosed.

## Description

### Background of the Invention

The present invention relates to an integrated circuit chip having a reinforcing member, a method of manufacturing the same, an IC card incorporating an integrated circuit chip, and a method of manufacturing the same.

As telephone cards currently used for public telephones, magnetic cards are generally used. Since the amount of information that can be stored in such a magnetic card is small, the card cannot cope with various new services. For this reason, the use of IC cards have been studied.

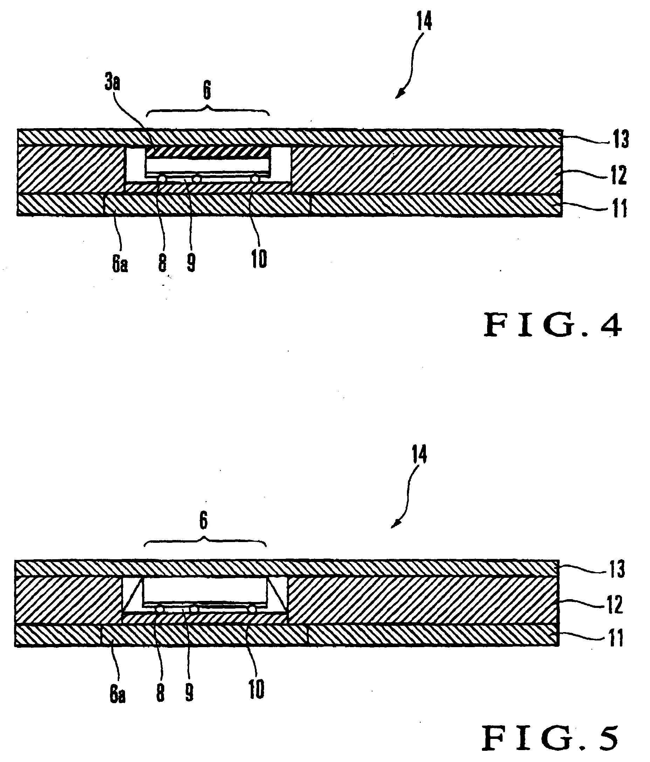

An IC card under development has a structure like the one shown in Fig. 5. An integrated circuit chip (to be referred to as an IC chip hereinafter) 6 is mounted on an IC card substrate 10 by a flip chip mounting method. Electrodes 6a for exchanging signals with the outside are formed on the lower surface of the IC card substrate 10, and the bump 8 side on which the integrated circuit is formed is capsulated with a underfill resin 9, thereby forming a module. This module is mounted on the card main body made up of card bases 11, 12, and 13 so as to form an IC card 14 as a whole.

As described above, the IC card is designed such that an IC chip storing various data is embedded in a resin card, arid an electrode, coil, and the like, connected to the embedded IC chip are formed on the card surface. The IC card also has the function of allowing a read/write of data in contact or noncontact with an external device through the electrode or the like formed on the card surface. An IC card having such an arrangement is designed to store data in the incorporated IC chip or the like upon converting the data into an electrical signal, and hence provides high security and can store/hold much more information. A magnetic card does not have these merits.

In many of IC cards described above, a card base is made of a plastic material such as PET (polyethylene terephthalate) or vinyl chloride, and an IC chip inserted into the IC card is embedded in the card base. The IC chip is therefore protected against humidity or the like from the outside.

Many of currently available IC cards are about 0.76 mm thick in consideration of portability. An IC card type telephone card issued by NTT (Nippon Telegraph and Telephone Corporation) will be as thin as about 0.5 mm. Note that an IC card having a thickness of 0.25 mm, which is thinner than the 0.5-mm thick card, has already been under development.

As described above, IC cards tend to become thinner year by year. Obviously, as IC cards become thinner, the IC chips housed in the IC cards need to become thinner. In a 0.76-mm thick IC, the thickness of an IC chip to be housed is set to about 0.2 to 0.25 mm. In a 0.25-mm thick IC card, an IC chip must be as thin as 0.05 mm.

As IC chips become thinner, wafers and IC chips will become defective at a higher probability because they are cracked in the process of manufacturing IC chips in a wafer state or the process of mounting IC chips cut from wafers. As IC chips become thinner, the yield in the IC chip mounting process decreases. In addition, since thin wafers and IC chips must be carefully handled in every operation in the steps of manufacturing and mounting IC chips, the operation efficiency deteriorates, resulting in a decrease in productivity.

In addition, as IC chips become thinner, they decrease in durability. Even if an IC chip becomes thinner, if a card incorporating the IC chip becomes thick, the card is not easily bent, and no stress acts on the IC chip. The purpose of making the IC chip thin is to make the IC card thin. The thin IC card becomes easier to bend, and a bending stress tends to act on the IC chip. The thinner an IC chip, the easier it is bent. When silicon used for an IC chip is compared with a polymeric material such as PET used for a card base, the silicon is more resistant to bending, and hence the IC chip is susceptible to damage.

In order to improve the durability of these thinned IC cards, various measures have been taken to protect thin-film IC chips in the IC cards from external force. For example, according to the technique disclosed in Japanese Patent Laid-Open No. 3-158296, a structure in which a reinforcing member is attached to an IC chip and the IC chip is fixed to a mount substrate through the reinforcing member has been proposed. According to the technique disclosed in Japanese Patent Laid-Open No. 8-324166, an IC module structure in which a reinforcing member attached in advance to a surface of an IC chip other than its terminal surface has been proposed.

According to a conventional method of attaching reinforcing members to IC chips, reinforcing members each formed to have the same size as that of each of divided IC chips are bonded thereto one by one. This method, however, requires a long process time and high cost. For this reason, a method of shortening the time required to bond reinforcing members is disclosed in Japanese Patent Laid-Open No. 9-263082.

According to the technique disclosed in Japanese Patent Laid-Open No. 9-263082, after a wafer on which IC chips are formed is cut in units of chips, the cut chips are fixed to a transfer sheet in the form of a wafer. In addition, reinforcing members divided and arranged in the same manner as the chips are fixed to another transfer sheet in advance, and the chips and reinforcing members are overlaid and bonded to each other. According to this method, since reinforcing members can be simultaneously bonded to a plurality of IC chips, the bonding time can be shortened. In addition, in mounting the IC chips, the use of the IC chips to which the reinforcing members have already been attached will facilitate handling even the thin-film IC chips in the mounting process.

In the prior art, however, a metal material is used for each reinforcing member. Since the metal material thermally expands more than a semiconductor material, a mechanical stress tends to act on each IC chip. If, therefore, a metal material is used for a reinforcing member, since much heat is applied to an IC chip in the process of mounting the IC chip in a card, control of heating is sometimes difficult to perform.

In the method disclosed in Japanese Patent Laid-Open No. 9-263082, positioning is required to overlay transfer sheets on each other. This makes it difficult to manufacture IC chips with reinforcing members. If positioning fails, many IC chips become defective at once, a large loss may occur. In order to perform accurate positioning, a positioning unit having a new positioning mechanism is required in addition to a conventional unit in the mounting process, resulting in an increase in facility cost.

In summary, according to the prior art, IC chips with reinforcing members cannot be easily manufactured.

### Summary of the Invention

The present invention has been made to solve the above problems, and has as its object to easily manufacture integrated circuit chips (IC chips) to which reinforcing members are bonded.

In order to achieve the above object, according to the present invention, there is provided an integrated circuit chip comprising an integrated circuit body having a predetermined integrated circuit formed on a major surface, and a reinforcing member which is formed by a fiber reinforced plastic obtained by compounding a resin with a fiber material and is bonded to a substantially entire lower surface of the integrated circuit body.

### Brief Description of the Drawings

Figs. 1A to 1F are views for explaining the steps in a method of manufacturing IC chips according to an embodiment of the present invention;
Figs. 2A and 2B are plan views for explaining a dicing method in Fig. 1E;
Figs. 3A to 3G are views for explaining the steps in a method of manufacturing IC chips in another embodiment of the present invention;
Fig. 4 is a sectional view showing the arrangement of an IC card manufactured by the present invention;
Fig. 5 is a sectional view showing the arrangement of a conventional IC card;
Fig. 6 is a graph showing the relationship between the height from which a weight is dropped and the thickness of a reinforcing member (carbon fiber thickness) in a shock/drop test;
Figs. 7A and 7B are sectional views showing the arrangement of an IC card manufactured by the present invention; and
Figs. 8A and 8B are sectional views showing the arrangement of an IC card manufactured by the present invention.

### Description of the Preferred Embodiments

The embodiments of the present invention will be described below with reference to the accompanying drawings.

### 〈First Embodiment〉

A method of manufacturing IC chips according to an embodiment of the present invention will be described first.

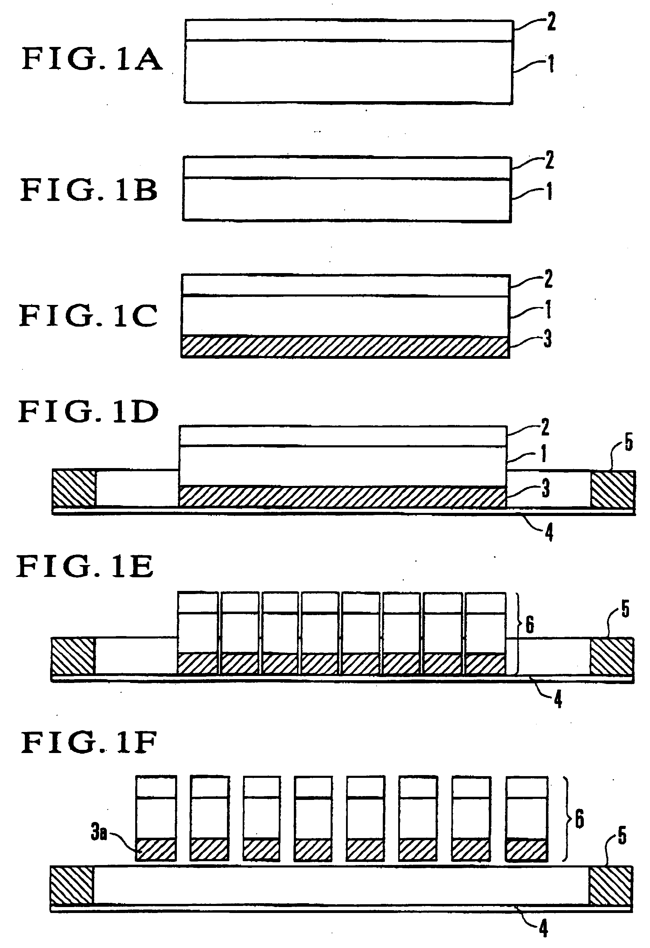

First of all, as shown in Fig. 1A, an IC (Integrated Circuit) 2 is formed on the major surface of a wafer 1 (semiconductor substrate 1) made of a semiconductor such as silicon. As shown in Fig. 1B, then, the wafer 1 is ground/polished or etched from the opposite surface of the wafer 1 to the surface on which the IC 2 is formed, thereby thinning the wafer 1.

When the wafer 1 is to be thinned, the thickness of the wafer is determined in accordance with the thickness of a completed IC card. If, for example, the thickness of the completed IC card is 0.76 mm, the wafer 1 is thinned to a thickness of 0.1 to 0.15 mm. If the thickness of the IC card is 0.25 mm, the wafer is thinned to about 0.05 mm. Obviously, even if the thickness of the IC card is 0.76 mm, the wafer 1 can be thinned to about 0.05 mm. Although not shown, when the wafer 1 is to be thinned, a protective tape or the like may be temporarily bonded to the surface on which the IC 2 is formed so as to prevent damage to the IC 2.

In this embodiment, as shown in Fig. 1C, a reinforcing plate 3 formed by using a fiber reinforced plastic plate (carbon fiber plate) obtained by compounding a resin with carbon fibers (fiber member) is bonded to the entire rear surface of the thinned wafer 1 with an adhesive.

The carbon fiber plate is a fiber reinforced plastic plate formed by arranging carbon fibers, a bundle of thin carbon threads each having a diameter of several microns, parallel or in the form of a fabric, impregnating the fibers with a thermoset resin such as an epoxy resin or the like and hardening them into sheets, and stacking the carbon fiber sheets on each other in the form of a plate. When the sheets are stacked in the form of a plate, the sheets are stacked on each other such that the directions of fibers of adjacent sheets differ from each other by 90°. A carbon fiber plate having a strength similar to and a weight smaller than a metal plate such as a stainless steel plate having the same thickness. In addition, the carbon fiber plate thermally expands less than the metal plate.

In bonding the reinforcing plate 3 formed by this carbon fiber plate, first of all, the reinforcing plate 3 and an adhesive sheet are overlaid on each other, and the resultant structure is heated at 70 to 80°C for about 1 min, thereby temporarily bonding the adhesive sheet to the reinforcing plate 3. As the adhesive sheet, an epoxy-based adhesive sheet or polyimide-based adhesive sheet may be used. Note that the bonding conditions change depending on the adhesive sheet to be used.

Subsequently, the reinforcing plate 3 and the wafer 1 are brought into contact with each other on the temporarily bonded adhesive sheet, and the resultant structure is heated at 70 to 80°C for about 1 min, thereby temporarily bonding the reinforcing plate 3 to the wafer 1. When the reinforcing plate 3 and wafer 1 are temporarily bonded to each other, a protective tape or the like is peeled off from the wafer 1. The resultant structure is then heat-treated at 150°C for 1 hr to strengthen the bonding between the wafer 1 and the reinforcing plate.

The thickness of the reinforcing plate may be properly changed in accordance with the thickness of a completed IC card, the thickness of a substrate on which an IC chip is mounted, and the like. In an IC card in which the above substrate thickness is 0.76 to 0.25 mm, the thickness of the reinforcing plate falls within the range of 20 to 100 µm. Note that when a reinforcing member formed by a reinforcing plate is attached, the apparent thickness of an IC chip becomes larger than the initial thickness by 30 to 200 µm or more. Since the thickness increases when the reinforcing member is attached in this manner, a thickness must be selected for the reinforcing plate in consideration of the thickness of the IC card and the thickness of the completed IC chip.

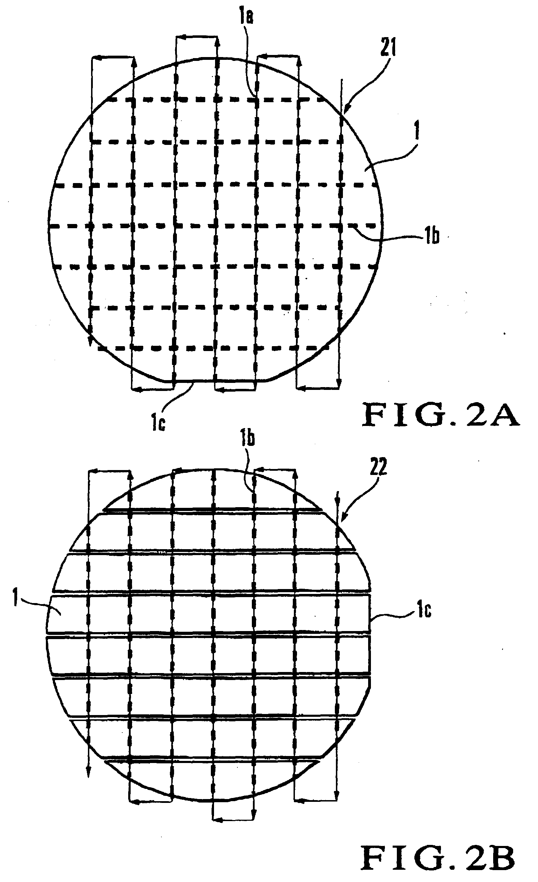

When the reinforcing plate 3 is boded to the rear surface of the wafer 1 in the above manner, the wafer 1 to which the reinforcing plate 3 is attached is bonded to a dicing tape (sheet) 4 stretched over an annular carrier 5. When the wafer is boded to the dicing tape 4, the wafer 1 is diced, together with the reinforcing plate 3 bonded to the wafer 1, as shown in Fig. 1E. The dicing is a technique of cutting the wafer 1 into chips (dies) by forming cut grooves in the wafer in the form of cubes. In dicing for an IC using a silicon substrate, in general, the wafer 1 is cut in the form of cubes as shown in Figs. 2A and 2B by grinding/cutting using a diamond blade as a peripheral cutting edge, which is obtained by solidifying abrasive grains such as diamond with a binder.

More specifically, a diamond blade attached to the distal end of a spindle designed to rotate high speed is rotated at 30,000 to 60,000 rpm, and the wafer 1 is cut along scribing lines 1a and 1b by using the diamond blade that rotates at high speed. First of all, as shown Fig. 2A, the wafer 1 is placed such that an orientation flat 1c becomes perpendicular to the rotational direction of the diamond blade (not shown), and the wafer 1 is moved to set the diamond blade at a point 21, thereby making the diamond blade, which is rotating at high speed, cut in the wafer 1. The wafer 1 is then moved such that the diamond blade moves on the chain lines in the directions indicated by the arrows, thereby cutting the wafer 1 along the scribing lines 1a in the direction perpendicular to the orientation flat 1c.

Subsequently, as shown in Fig. 2B, the wafer 1 is rotated through 90° to be located such that the orientation flat 1c becomes parallel to the rotational direction of the diamond blade (not shown). The wafer 1 is then moved to place the diamond blade at a point 22, and the diamond blade which is rotating at high speed is made to cut in the wafer 1. Thereafter, the wafer 1 is moved to make the diamond blade move on the chain lines in the directions indicated by the arrows, thereby cutting the wafer 1 along scribing lines 1b parallel to the orientation flat 1c. With the above operation, the wafer 1 bonded to the dicing tape 4 is cut into IC chips (Integrated Circuit chips) 6 together with the bonded reinforcing plate 3. Since the reinforcing plate 3 is a carbon fiber plate, it can be cut with the diamond blade.

According to the above description, the reinforcing plate 3 is bonded to the dicing tape 4. However, the surface of the wafer 1 on which the IC 2 is formed may be bonded to the dicing tape 4, and the wafer 1 may be diced by cutting it upon scribing the lower surface of the reinforcing plate 3.

As described above, after the wafer 1 to which the reinforcing plate 3 is boded is diced, the IC chips 6 with the reinforcing members 3a formed by reinforcing plates are removed from the dicing tape 4, as shown in Fig. 1F. When each IC chip 6 is to be removed from the dicing tape 4, since a reinforcing member 3a formed by a reinforcing plate is formed on the lower surface of the IC chip 6, the chance of damage to IC chips decreases.

After each IC chip 6 is formed, as shown in Fig. 4, the IC chip 6 to which the reinforcing member 3a formed by a carbon fiber plate is mounted on an IC card substrate 10 by a flip chip mounting method using bumps 8. In this mounting process as well, since the reinforcing member 3a is formed on the IC chip 6, the chance of damage in the mounting process is reduced. When the IC chip 6 is mounted on the IC card substrate 10 having a rear surface on which electrodes 6a for exchanging signals with the outside are formed, the IC formation surface is encapsulated with an underfill resin 9 to form a module. This completed module is mounted in a card, body constituted by card bases 11, 12, and 13 made of a plastic material such as polyethylene terephthalate, thus forming an IC card 14.

The strength increasing effect of the above IC chip with the reinforcing member 3a will be described below. An IC card was formed, in which a 50-µm thick IC chip reinforced with a reinforcing member formed by a carbon fiber plate was embedded, was formed, and a shock/drop test was performed. The shock/drop test was conducted by placing the above IC card on a silicone rubber plate, placing a punch at a position where this IC chip was embedded, and dropping a weight on the punch from a predetermined height. The weight weighed 30g. The radius of curvature of the punch distal end in contact with the IC card was set to 10 mm. This shock/drop test was conducted on the assumption that a user mistakenly dropped an IC card and stamped the card with the heel of a shoe.

In the above shock/drop test, after the weight was repeatedly dropped 30 times, cracks in the IC chip inside the IC card were observed with an ultrasonic microscope. In this observation, if no crack was detected in the IC chip, the height from which the weight was to be dropped was increased, and a shock/drop test was conducted again. In this manner, the height at which a crack was produced was obtained.

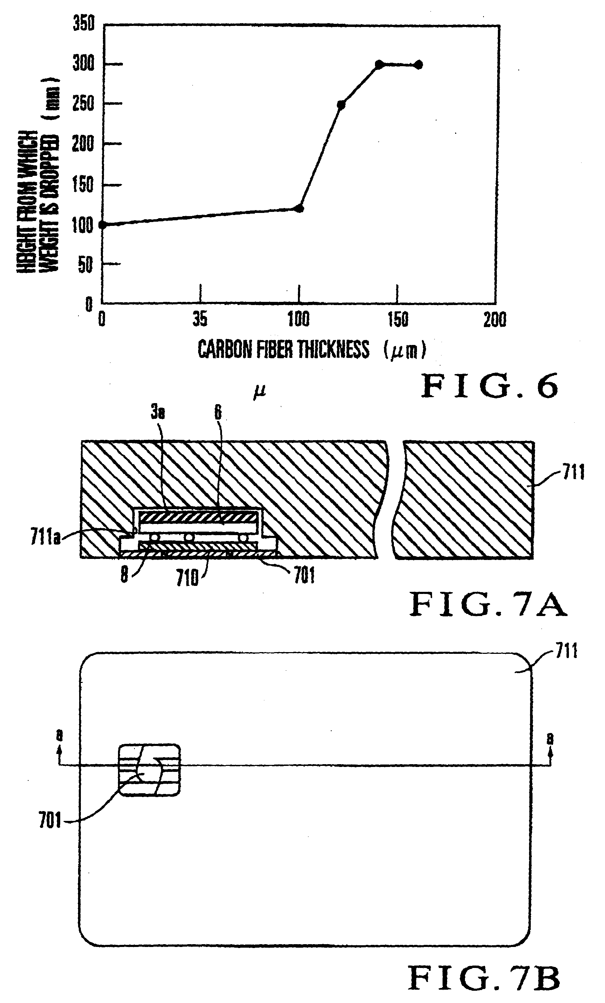

Fig. 6 shows the result of this test. The carbon fiber thickness indicates the thickness of the reinforcing plate, and a carbon fiber thickness of 0 indicates an IC chip using no reinforcing member. When no reinforcing member is used, the IC chip in the IC card was not damaged up to a height of 10 cm from which a weight of 30 g was dropped.

In the case of the IC chip reinforced with a carbon fiber thickness of 100 µm, the IC chip in the IC card was not damaged up to a height of 12 cm. Obviously, as the thickness of a reinforcing member increases, the height from which the weight is dropped and no crack is produced increases, and the IC chip becomes resistant to a larger shock. As is obvious from this test, the strength of each IC chip can be increased by the reinforcing member.

Note that the form of an IC card is not limited to the one shown in Fig. 4. For example, as shown in Fig. 7, the IC chip 6 to which the reinforcing member 3a is attached may be mounted on a mount substrate 710 having a rear surface on which a electrode plate 701 is formed by the flip chip IC mounting method using the bumps 8, and the resultant structure may be fitted in a recess portion 711a formed in a predetermined portion of a card base 711, thus forming a contact type IC card 714.

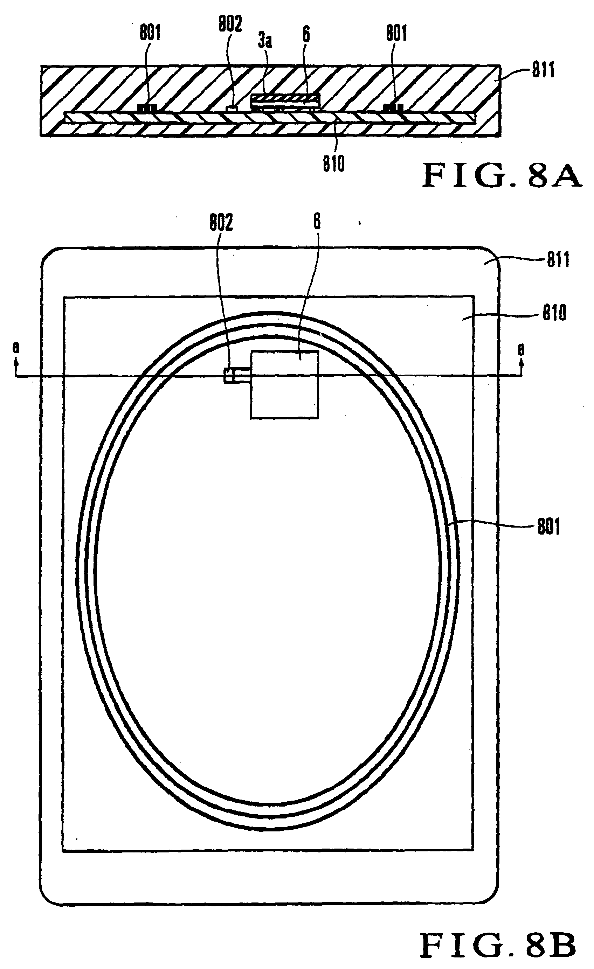

Furthermore, as shown in Fig. 8, the IC chip 6 to which the reinforcing member 3a is attached may be mounted on a mount substrate 810, on which a coil-like antenna 801 is formed and in which a capacitor 802 is mounted, by the flip chip IC mounting method using the bumps 8 while the IC chip 6 is in contact with the antenna 801 and capacitor 802. These components may be embedded in a card base 811 to form a noncontact type IC card 814.

### 〈Second Embodiment〉

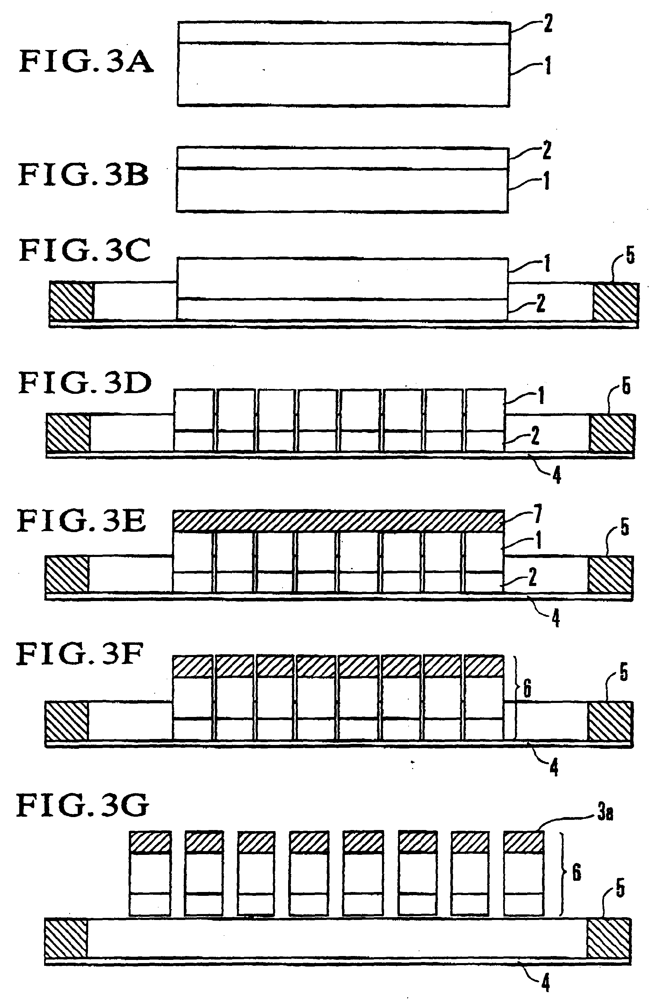

A method of manufacturing IC chips according to another embodiment of the present invention will be described next with reference to Figs. 3A to 3G. Note that the same reference numerals as in Figs. 1A to 1F denote the same parts as in Figs. 3A to 3G.

First of all, as shown in Fig. 3A, ICs 2 are formed on a wafer 1 in units of chips. As shown in Fig. 3B, the opposite surface of the wafer 1 to the surface on which the ICs 2 are formed is then ground/polished or etched to thin the wafer 1. This process is the same as that in the above embodiment up to the step of thinning the wafer 1. Obviously, although not shown, when the wafer 1 is thinned, a tape or the like is bonded to the surface on which the ICs 2 are formed to protect the ICs 2 and prevent damage to the ICs 2.

When the wafer 1 is thinned, the wafer 1 is fixed to a dicing tape 4 stretched over an annular carrier 5 such that the surface on which the ICs 2 are formed is bonded to the dicing tape 4. Subsequently, as shown in Fig. 3D, the wafer 1 is diced in units of IC chips by cutting the wafer 1 front its lower surface. In this dicing, the wafer 1 may be cut with a diamond blade, as shown in Figs. 2A and 2B.

In cutting from the lower surface of the wafer 1, the surface on which the ICs 2 are formed cannot be seen, and hence scribing lines are difficult to check. If, however, the coordinate points of chip arrays within the wafer 1 are measured in advance, dicing can be done from the lower surface of the wafer 1 without seeing the surface on which the ICs 2 are formed. In addition, since a silicon wafer transmits infrared rays, if a dicing unit having an infrared microscope is used, an operator can perform dicing from the lower surface of the wafer 1 while observing the ICs and scribing lines on the upper surface with transmitted infrared images.

When the wafer 1 is cut, a reinforcing plate 7 formed by a single carbon fiber plate is bonded to the entire lower surface (the surface on which no ICs 2 are formed) of the wafer 1 cut as shown in Fig. 3E. The reinforcing plate 7 may be bonded by using a method of overlaying the reinforcing plate 7 on the lower surface of the cut wafer 1 on which an adhesive sheet is bonded. Alternatively, an adhesive may be applied to the reinforcing plate 7 in advance, and the reinforcing plate 7 with the adhesive may be bonded to the lower surface of the wafer 1. The reinforcing plate 7 formed by the signal carbon fiber plate and having an integral structure need not always have the same shape as that of the wafer 1 as long as it can cover all the IC chips on the wafer 1 cut on the dicing tape 4. The reinforcing plate 7 bonded in the step shown in Fig. 3E may have a larger area than the wafer 1.

When the reinforcing plate 7 formed by the carbon fiber plate having the integral structure is bonded to the wafer 1, the reinforcing plate 7 is cut, as shown in Fig. 3F. In this cutting, scribing lines may be made in the reinforcing plate 7 with a predetermined blade along the scribing lines on the wafer 1 which has already been cut. In this case, inhibiting the blade from reaching the wafer 1 under the reinforcing plate 7 by adjusting the cutting depth of the blade will prevent damage to the end faces of chips that have already been cut. If the cutting depth of the blade is difficult to adjust, a wide diamond blade may be used to cut the wafer 1, and a blade narrower than the diamond blade used to cut the wafer 1 is used to cut the reinforcing plate 7, damage to the end faces of chips that have already been divided can be prevented.

When the reinforcing plate 7 is cut, IC chips 6 having reinforcing members 3a formed on their lower surfaces are peeled off from the dicing tape 4 as shown in Fig. 3G, and each peeled IC chip 6 is flip-chip-mounted on an IC card substrate 10 with bumps 8. Electrodes 6a for exchanging signals with the outside are formed on the lower surface of the IC card substrate 10. The mount surface is then encapsulated with an underfill resin 9 to form a module. This module is mounted in a card body constituted by card bases 11, 12, and 13, thus forming an IC card 14.

As described above, in this embodiment as well, since the reinforcing member 3a is formed on the lower surface of the IC chip 6, the chance of damage to the IC chip in removing the IC chip 6 from the dicing tape 4 is reduced. In addition, in the mounting step as well, since the reinforcing member 3a is formed on the IC chip 6, the change of damage in mounting is reduced.

In this embodiment, since a wafer is cut before a reinforcing plate is bonded thereto, the wafer can be cut without changing the conventional dicing conditions. This makes it possible to suppress the occurrence of cracks and flows in the cut surface of a wafer which cause chip fractures as compared with the case wherein the wafer is cut with the reinforcing plate being bonded thereto.

In the above embodiments, a carbon fiber plate is used as a reinforcing plate. However, the present invention is not limited to this. For example, a glass fiber plate may be used, which is a fiber reinforced plastic plate obtained by using fibers of high-melting glass (glass fibers) such as Pilex glass (available from Corning) may be used as a fiber material, and stacking sheets formed by impregnating the fibers with a resin (thermoset resin). Alternatively, a plate member may be used as a reinforcing plate, which is obtained by stacking sheets formed by using a mixture of carbon and glass fibers as a fiber material and impregnating the material with a resin. A glass fiber plate thermally expands less than a metal plate.

As has been described above, according to the present invention, a reinforcing plate formed by a fiber reinforced plastic obtained by compounding a resin with a fiber material such as a carbon fiber or glass fiber is divided after it is bonded to a semiconductor substrate, and a reinforcing member formed by a reinforcing plate is formed on the lower surface of an IC chip lower surface. Therefore, an IC chip (semiconductor device) with a reinforcing member can be easily manufactured.

## Claims

1. An integrated circuit chip characterized by:
an integrated circuit (1, 2) body having a predetermined integrated circuit formed on a major surface; and
a reinforcing member (3a) which is formed by a fiber reinforced plastic obtained by compounding a resin with a fiber material and is bonded to a substantially entire lower surface of said integrated circuit body.

2. A chip according to claim 1, wherein the fiber reinforced plastic is obtained by compounding a thermoset resin with a fiber material.

3. A chip according to claim 1, wherein the fiber material is a carbon fiber.

4. A chip according to claim 1, wherein the fiber material is a glass fiber.

5. A chip according to claim 1, wherein the fiber material is made of glass and carbon fibers.

6. An IC card characterized by an integrated circuit chip including
an integrated circuit body having a predetermined integrated circuit formed on a major surface, and
a reinforcing member which is formed by a fiber reinforced plastic obtained by compounding a resin with a fiber material and is bonded to a substantially entire lower surface of said integrated circuit body.

7. A card according to claim 6, wherein the fiber reinforced plastic is obtained by compounding a thermoset resin with a fiber material.

8. A card according to claim 6, wherein the fiber material is a carbon fiber.

9. A card according to claim 6, wherein the fiber material is a glass fiber.

10. A card according to claim 6, wherein the fiber material is made of glass and carbon fibers.

11. An integrated circuit chip manufacturing method characterized by:
the step of forming a plurality of integrated circuits (2) on a major surface of a semiconductor substrate (1) in an arrayed state;
the step of thinning the semiconductor substrate, on which the integrated circuits are formed, by cutting an entire lower surface of the substrate;
the step of bonding a reinforcing plate (3) obtained by compounding a resin with a fiber material to the entire lower surface of the thinned semiconductor substrate; and
the step of forming a plurality of integrated circuit chips by dividing the semiconductor substrate to which the reinforcing plate (3a) is bonded into portions each having a predetermined shape and by bonding reinforcing members formed by the reinforcing plates to integrated circuit bodies.

12. A method according to claim 11, further comprising forming the integrated circuit chips by simultaneously dividing the reinforcing plate and the semiconductor substrate.

13. A method according to claim 11, further comprising:
the step of bonding the major surface of the semiconductor substrate (1), on which the integrated circuits are formed, to a sheet (4) having a wider area than the semiconductor substrate before bonding the reinforcing place to the semiconductor substrate;
the step of forming a plurality of integrated circuit bodies by dividing the semiconductor substrate into portions each having a predetermined shape after bonding the semiconductor substrate to the sheet;
the step of boding the reinforcing plate to the entire lower surface of the semiconductor substrate while the semiconductor substrate divided into the plurality of integrated circuit bodies is bonded to the sheet;
the step of forming a plurality of integrated circuit chips by dividing the reinforcing plate into portions having a predetermined shape like the semiconductor substrate and by bonding reinforcing members (7) formed by the reinforcing plate to the integrated circuit bodies; and
the step of peeling off the integrated circuit chips from the sheet.

14. A method according to claim 11, wherein the fiber reinforced plastic is obtained by compounding a thermoset resin with a fiber material.

15. A method according to claim 11, wherein the fiber material is a carbon fiber.

16. A method according to claim 11, wherein the fiber material is a glass fiber.

17. A method according to claim 11, wherein the fiber material is made of glass and carbon fibers.

18. An IC card manufacturing method characterized by;
the step of forming a plurality of integrated circuits on a major surface of a semiconductor substrate in an arrayed state:
the step of thinning the semiconductor substrate, on which the integrated circuits are formed, by cutting an entire lower surface of the substrate;
the step of bonding a reinforcing plate obtained by compounding a resin with a fiber material to the entire lower surface of the thinned semiconductor substrate;
the step of forming a plurality of integrated circuit chips by dividing the semiconductor substrate to which the reinforcing plate is bonded into portions each having a predetermined shape and by bonding reinforcing members formed by the reinforcing plates to integrated circuit bodies;
the step of preparing a card base for incorporating the integrated circuit chip; and
the step of forming an IC card by embedding the integrated circuit chip in the card base.

19. A method according to claim 18, further comprising forming the integrated circuit chips by dividing the reinforcing plate and the semiconductor substrate substantially at once.

20. A method according to claim 18, further comprising:
the step of bonding the major surface of the semiconductor substrate, on which the integrated circuits are formed, to a sheet having a wider area than the semiconductor substrate before bonding the reinforcing place to the semiconductor substrate;
the step of forming a plurality of integrated circuit bodies by dividing the semiconductor substrate into portions each having a predetermined shape after bonding the semiconductor substrate to the sheet;
the step of boding the reinforcing plate to the entire lower surface of the semiconductor substrate while the semiconductor substrate divided into the plurality of integrated circuit bodies is bonded to the sheet;
the step of forming a plurality of integrated circuit chips by dividing the reinforcing plate into portions having a predetermined shape like the members formed by the reinforcing plate to the integrated circuit bodies;
the step of peeling off the integrated circuit chips from the sheet;
the step of preparing a card base for incorporating the integrated circuit chip; and
the step of forming an IC card by embedding the integrated circuit chip in the card base.

21. A method according to claim 18, wherein the fiber material is a carbon fiber.

22. A method according to claim 18, Wherein the fiber material is a glass fiber.

23. A method according to claim 18, wherein the fiber material is made of glass and carbon fibers.
